(19) Europäisches Patentamt
European Patent Office
Office européen des brevets

(11) **EP 2 240 984 B1**

(12) **EUROPÄISCHE PATENTSCHRIFT**

(45) Veröffentlichungstag und Bekanntmachung des Hinweises auf die Patenterteilung:
**30.04.2014 Patentblatt 2014/18**

(21) Anmeldenummer: **09711396.3**

(22) Anmeldetag: **05.02.2009**

(51) Int Cl.:
***H01S 5/40*** *(2006.01)*    ***G02B 27/00*** *(2006.01)*
*H01S 5/022* *(2006.01)*    *G02B 19/00* *(2006.01)*

(86) Internationale Anmeldenummer:
**PCT/EP2009/000765**

(87) Internationale Veröffentlichungsnummer:
**WO 2009/100845 (20.08.2009 Gazette 2009/34)**

(54) **DIODENLASERSTRUKTUR ZUR ERZEUGUNG VON DIODENLASERSTRAHLUNG MIT FASERKOPPLUNGSOPTIMIERTEM STRAHLPARAMETERPRODUKT**

DIODE LASER ARRAY FOR CREATING DIODE LASER OUTPUT WITH OPTIMISED BEAM PARAMETER PRODUCTS FOR FIBRE COUPLING

STRUCTURE LASER À DIODES DESTINÉE À LA PRODUCTION DE FAISCEAUX LASER AYANT UN PRODUIT DE PARAMÈTRES DE FAISCEAU OPTIMISÉ QUANT AU COUPLAGE DE FIBRES

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(30) Priorität: **11.02.2008 EP 08002444**

(43) Veröffentlichungstag der Anmeldung:
**20.10.2010 Patentblatt 2010/42**

(73) Patentinhaber: **TRUMPF Laser GmbH + Co. KG 78713 Schramberg (DE)**

(72) Erfinder:
• **STROHMAIER, Stephan, Gregor, Patrick 78733 Aichhalden (DE)**

• **TILLKORN, Christoph 78658 Zimmern (DE)**

(74) Vertreter: **Kohler Schmid Möbus Patentanwälte Ruppmannstraße 27 70565 Stuttgart (DE)**

(56) Entgegenhaltungen:
JP-A- 5 110 187    JP-A- 6 132 610
JP-A- 2003 344 803    JP-A- 2007 214 300
JP-A- 2007 324 312    US-A- 5 565 693
US-A1- 2004 190 580    US-A1- 2004 233 964
US-A1- 2007 195 850    US-B1- 6 240 116

**Beschreibung**

Die vorliegende Erfindung betrifft eine Diodenlaserstruktur mit mehreren nebeneinander angeordneten Streifenemittern, die mit ihren SA-Achsen in der gleichen Richtung ausgerichtet und in dieser Richtung versetzt zueinander angeordnet sind, wobei die jeweils auf die SA-Achse bezogenen Strahlparameterprodukte zumindest einiger der Streifenemitter verschieden sind.

Eine derartige Diodenlaserstruktur ist beispielsweise durch die JP 6132610 A oder US 5 565 693 A bekannt geworden.

Für die Erzeugung von effizienter und hochbrillanter Diodenstrahlung werden gegenwärtig entweder mehrere Einzelemitter (Breitstreifenamitter mit typischen Breiten von 50 bis 500 μm) oder Diodenbarren bestehend aus mehreren gleich breiten Einzelemittern/Brettstreifenemittern (Diodenbarren aus typischerweise 10 bis 100 gleich breiten Breitstreifenemittem mit einem Füllfaktor von 10 bis 95%) verwendet. Beispielsweise finden Diodenbarren aus 30 bis 50 Emittern mit einer Breite von 100 μm auf einem 1 cm Barren mit einem Füllfaktor von 30 bis 50% häufig Verwendung.

Die streifenförmigen Einzelemitter eines Diodenbarrens emittieren jeweils einen Laserstrahl, der sich in einer so genannten FA(Fast Axis)-Richtung, in der der Strahl schnell divergiert, bspw. mit einem Abstrahlwinkel von ca. 50° und in einer dazu rechtwinkligen, so genannten SA(Slow Axis)-Richtung, in der der Strahl vergleichsweise langsam divergiert, bspw. mit einem Abstrahlwinkel von ca. 10°, ausbreitet. Die FA-Richtung weist die höchstmögliche (nahezu beugungsbegrenzte) Strahlqualität, die SA-Richtung hingegen eine relativ schlechte Strahlqualität auf. Um diese Einzelstrahlen zusammenzufassen, werden sie zunächst in der FA-Richtung mittels einer mikrooptischen Zylinderlinse kollimiert und anschließend mit Hilfe einer Zylinderlinsen-Reihe (Array) eine Kollimation in SA-Richtung vorgenommen. Danach werden die Strahlen mittels einer weiteren Mikrooptik um 90° gedreht und nebeneinander angeordnet. Der so geformte Laserstrahl ist also durch bündige optische Stapelung der von den streifenförmigen Einzelemittern emittierten Laserstrahlstreifen gebildet. Da die Einzelemitter identisch sind, weisen ihre emittierten Laserstrahlen jeweils das gleiche auf die SA-Richtung bezogene Strahlparameterprodukt (BPP$_{SA}$) und das gleiche auf die FA-Richtung bezogene Strahlparameterprodukt (BPP$_{FA}$) auf, wobei das Strahlparameterprodukt BPP wie folgt definiert ist:

$$BPP_i = \theta_i \cdot w_i \quad (i = SA, FA)$$

mit

θ: Divergenz des vom Emitter emittierten Laserstrahls in SA- bzw. FA-Richtung,

w: halbe Breite des Emitters in SA- bzw. FA-Richtung.

Die bündige optische Stapelung der Laserstrahlstreifen mit jeweils gleichem BPP$_{SA}$ und BPP$_{FA}$ führt zu einem Laserstrahl, der ein in der BPP$_{SA}$-BPP$_{FA}$-Ebene rechteckiges bzw. quadratisches Strahlparameterprodukt aufweist und daher in eine runde Faser, welche ein in der BPP$_{SA}$-BPP$_{FA}$-Ebene rundes Strahlparameterprodukt aufweist, nur mit Strahlungsverlusten oder unter nicht vollständiger Ausnutzung der Faser eingekoppelt wird.

Aus der US 2007/0195850 A1 ist es zwar bekannt, Einzelemitter mit in SA-Richtung unterschiedlichen Emitterbreiten in FA-Richtung übereinander gestapelt anzuordnen und dadurch das auf die SA-Achse bezogene Strahlparameterprodukt jedes Emitters an das auf die SA-Achse bezogene Strahlparameterprodukt des zugehörigen Faserbereichs anzupassen. Allerdings sind das Handling und die Positionierung der einzelnen Emitter sehr aufwändig, und zudem erfordert diese Anordnung einen verhältnismäßig großen Bauraum.

Der Erfindung liegt deshalb die Aufgabe zugrunde, eine Diodenstruktur der eingangs genannten Art, insbesondere bestehend aus einem Diodenbarren mit Einzelemittern oder aber auch gestapelten Diodenbarren mit Einzelemittern in Form eines Diodenstacks, dahingehend weiterzubilden, dass das Strahlparameterprodukt der erzeugten Laserdiodenstrahlung in einfacher Weise und in kompakten Abmessungen an das runde Strahlparameterprodukt einer Faser, in die die Laserdiodenstrahlung eingekoppelt werden soll, angepasst ist.

Diese Aufgabe wird erfindungsgemäß nach dem Anspruch 1 dadurch gelöst, dass das jeweils auf die SA-Achse bezogene Strahlparameterprodukt der Streifenemitter ausgehend von der Mitte der Diodenlaserstruktur zu beiden Rändern der Diodenlaserstruktur hin, insbesondere spiegelsymmetrisch bzgl. der Mitte der Diodenlaserstruktur, abnimmt. Ergänzend können die Streifenemitter in ihrer Strahlausbreitungsrichtung zueinander versetzt sein.

Erfindungsgemäß weisen zumindest einige der in SA-Richtung nebeneinander angeordneten Streifenemitter unterschiedliche auf die SA-Achse bezogene Strahlparameterprodukte auf, die für eine optimierte Einkopplung in eine runde Faser jeweils an die auf die SA-Achse bezogenen Strahlparameterprodukte der zugehörigen Faserbereiche angepasst sind. Dazu sind die auf die SA-Achse bezogenen Strahlparameterprodukte der Streifenemitter bevorzugt derart gewählt, dass sie zu einem in der BPP$_{SA}$-BPP$_{FA}$-Ebene annähernd runden Strahlparameterprodukt optisch zusammensetzbar sind. Mit anderen Worten wird die Ausgangsstrahlung der Streifenemitter an die Faser in der SA-Richtung BPP-angepasst, so dass die Laserdiodenstrahlung mit hoher Effizienz in die Faser eingekoppelt werden kann. Durch Variation der Strahlparameterprodukte der Streifenemitter können also Ausgangsleistung und/oder Effizienz gesteigert werden. Diese Vorgehensweise ist auch auf andere Faserquerschnitte, wie bspw. elliptische Faserquerschnitte, übertragbar.

Vorzugsweise sind die Streifenemitter durch monochromatische Emitter, insbesondere Multimode-Emitter, mit jeweils der gleichen Laserwellenlänge gebildet. Dabei sind unter monochromatischen Emittern, d.h. Emittern mit einer Wellenlänge, im Rahmen der Anmeldung auch Emitter zu verstehen, die über eine gleiche Bandbreite emittieren.

Das Strahlparameterprodukt eines Streifenemitters kann über seine Breite und über die Divergenz des emittierten Laserstrahls eingestellt werden. Bei besonders bevorzugten Ausführungsformen sind zumindest einige der Streifenemitter in der Richtung ihrer SA-Achsen verschieden breit, während bei anderen bevorzugten Ausführungsformen zumindest einige der Streifenemitter eine jeweils auf die SA-Achse bezogene unterschiedliche Divergenz aufweisen.

Vorzugsweise sind einer oder mehrere der Streifenemitter jeweils durch einen einzigen Einzelemitter gebildet, so dass die erfindungsgemäße Diodenlaserstruktur unterschiedlich breite Einzelemitter aufweist, die die gleiche oder eine unterschiedliche auf die SA-Achse bezogene Divergenz aufweisen können.

Ebenfalls bevorzugt können einer oder mehrere der Streifenemitter jeweils durch mehrere unterschiedlich breite oder auch gleichbreite Einzelemitter gebildet sein, wobei der Abstand in SA-Richtung zwischen benachbarten Einzelemittern eines Streifenemitters kleiner als der Abstand in SA-Richtung zwischen benachbarten Streifenemittern ist. Dabei können die Einzelemitter die gleiche oder eine unterschiedliche auf die SA-Achse bezogene Divergenz aufweisen. Besonders bevorzugt sind unterschiedlich breite Streifenemitter jeweils durch eine unterschiedliche Anzahl von identischen Einzelemittern gebildet, wobei in diesem Fall die so gebildeten Streifenemitter die gleiche auf die SA-Achse bezogene Divergenz aufweisen.

Für den Fall einer Einkopplung der Laserdiodenstrahlung in eine Faser ist den Streifenemittern eine Optik nachgeordnet, die die von den Streifenemittern ausgehenden Laserstrahlen als in Richtung ihrer FA-Achsen optisch nebeneinander angeordnete parallele Laserstrahlstreifen auf eine runde Faser abbildet, wobei das auf die SA-Achse bezogene Strahlparameterprodukt jedes Laserstrahlstreifens an das auf die SA-Achse bezogene Strahlparameterprodukt des zugehörigen Faserbereichs angepasst ist, d.h. der Laserstrahlstreifen an seinen zugehörigen Faserbereich in der SA-Richtung BPP-angepasst ist.

Weitere Vorteile der Erfindung ergeben sich aus den Ansprüchen, der Beschreibung und der Zeichnung. Ebenso können die vorstehend genannten und die noch weiter aufgeführten Merkmale je für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Es zeigen:

Fig. 1 einen Diodenlaserbarren mit einer ersten erfindungsgemäßen Diodenlaserstruktur mit mehreren nebeneinander angeordneten, verschieden breiten Streifenemittern;

Fign. 2a bis 2c verschiedene Ausführungsbeispiele zweier verschieden breiter Streifenemitter entsprechend dem Detail II in Fig. 1;

Fig. 3 einen Diodenlaserbarren mit einer zweiten erfindungsgemäßen Diodenlaserstruktur mit mehreren nebeneinander angeordneten, verschieden divergenten Streifenemittern;

Fig. 4 den Strahlengang der von der erfindungsgemäßen Diodenlaserstruktur emittierten und mittels einer Optik in eine Faser eingekoppelten Laserstrahlen;

Fig. 5 in der $BPP_{SA}$-$BPP_{FA}$-Ebene die Strahlparameterprodukte der von den Streifenemittern ausgehenden und übereinander gestapelten Laserstrahlstreifen, deren auf die SA-Achse bezogenen Strahlparameterprodukte an das Strahlparameterprodukt des zugehörigen Faserbereichs angepasst sind;

Fign. 6a bis 6e weitere Barrenstrukturen der erfindungsgemäßen Diodenlaserstruktur; und

Fig. 7 einen Diodenstapel ("Diodenstack") aus mehreren Diodenlaserbarren mit jeweils der in Fig. 1 gezeigten ersten erfindungsgemäßen Diodenlaserstruktur.

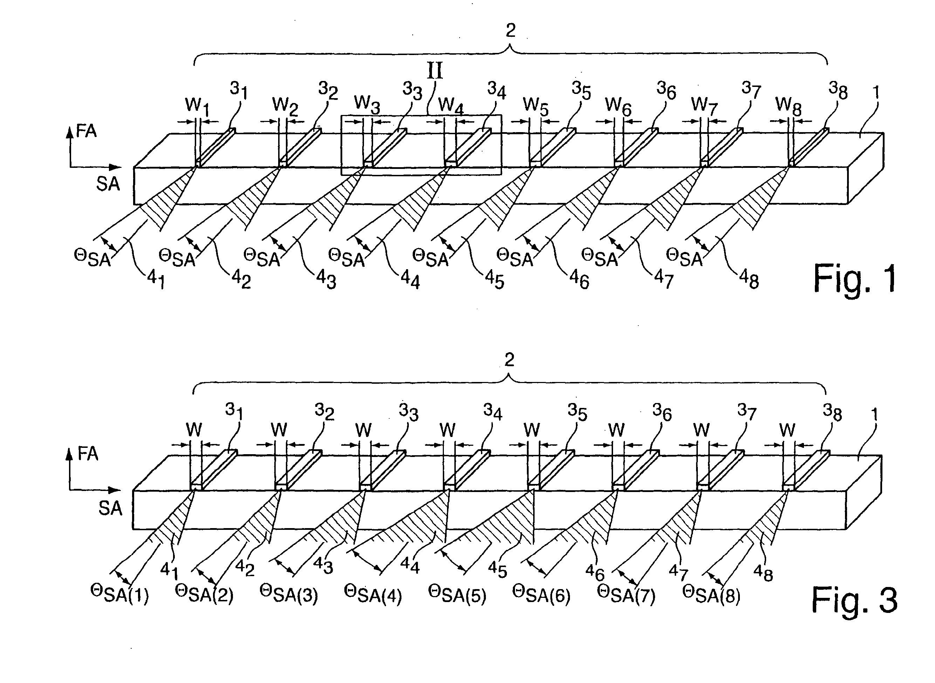

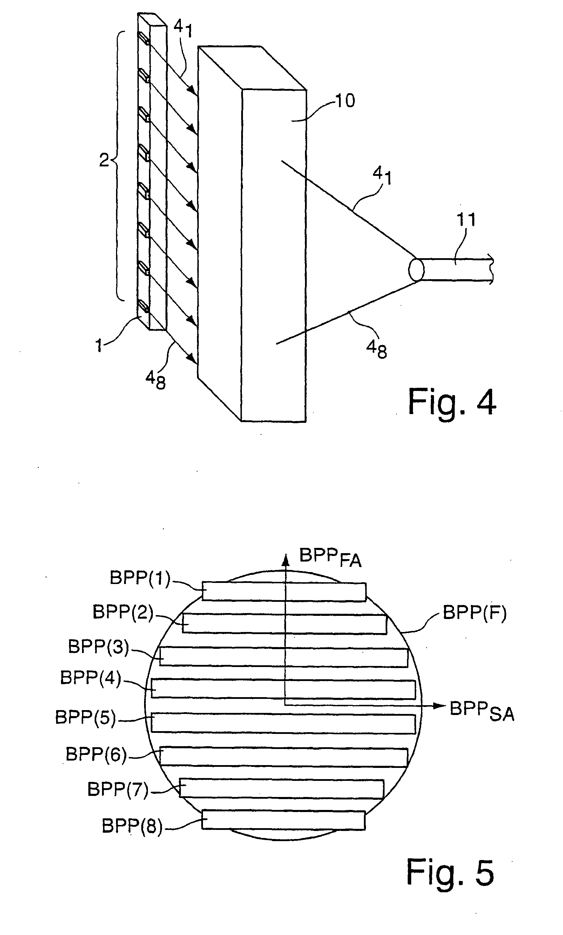

Der in **Fig. 1** gezeigte Diodenlaserbarren **1** weist eine Diodenlaserstruktur **2** mit acht parallel nebeneinander angeordneten Streifenemittern $\mathbf{3_1}$ bis $\mathbf{3_8}$ auf, die mit ihren SA-Achsen in der gleichen, in Fig. 1 waagerechten Richtung ausgerichtet und jeweils in dieser waagerechten Richtung versetzt zueinander angeordnet sind. Einige der Streifenemitter $3_1$ bis $3_8$ weisen in der SA-Richtung unterschiedliche Breiten $\mathbf{w_1}$ bis $\mathbf{w_8}$ auf, wobei die Breite der Streifenemitter $3_1$ bis $3_8$ ausgehend von der Mitte der Diodenlaserstruktur 2 zu beiden Rändern der Diodenlaserstruktur 2 hin, insbesondere spiegelsymmetrisch, abnimmt. Es gilt: $w_4 = w_5 > w_3 = w_6 > w_2 = w_7 > w_1 = w_8$. Beispielsweise beträgt die Breite der zentralen Emitter $3_4$, $3_5$ 50 bis 500 $\mu m$, insbesondere 100 bis 200 $\mu m$. Die Emitterbreite nimmt zu den Rändern hin von Emitter zu Emitter jeweils bis zu 50 %, insbesondere bis zu 30 %, ab. Die Abnahme der Emitterbreite von Emitter zu Emitter kann sowohl relativ als auch absolut gleich oder unterschiedlich sein. Die von den Streifenemitter $3_1$ bis $3_8$ emittierten Laserstrahlen $4_1$ bis $4_8$ weisen in der SA-Richtung die gleiche Divergenz $\theta_{SA}$ auf. Entsprechend ist das auf die SA-Richtung bezogene Strahlparameterprodukt $BPP_{SA}(i) = w_{SA}(i) * \theta_{SA}(i) = w_{SA}(i) * \theta_{SA}$ (i = 1, ..., 8) in der Mitte der Diodenlaserstruktur 2 am größten und nimmt zu den beiden Rändern der Diodenlaserstruktur 2 hin ab, d.h., es gilt: $BPP_{SA}(4) = BPP_{SA}(5) > BPP_{SA}(3) = BPP_{SA}(6) > BPP_{SA}(2) = BPP_{SA}(7) > BPP_{SA}(1) = BPP_{SA}(8)$. Hingegen weisen die Streifenemitter $3_1$ bis $3_8$ in der FA-Richtung die gleiche Höhe und ihre emittierten Laserstrahlen $4_1$ bis $4_8$ in FA-Richtung die gleiche Divergenz auf. Wie unten mit Bezug auf Fig. 5 noch näher beschrieben wird, sind die auf die SA-Achse bezogenen Strahlparameterprodukte $BPP_{SA}(1)$ bis $BPP_{SA}(B)$ der Streifenemitter $3_1$ bis $3_8$ derart gewählt, dass sie zu einem in der $BPP_{SA}$-$BPP_{FA}$-Ebene annähernd runden Strahlparameterprodukt optisch zusammensetzbar sind.

Vorzugsweise sind die Streifenemitter $3_1$ bis $3_8$ durch monochromatische Emitter, insbesondere Multimode-Emitter, mit jeweils der gleichen Laserwellenlänge gebildet, wobei unter monochromatischen Emittern, d.h. Emittern mit einer Wellenlänge, im Rahmen der Anmeldung auch Emitter zu verstehen sind, die über eine gleiche Bandbreite emittieren.

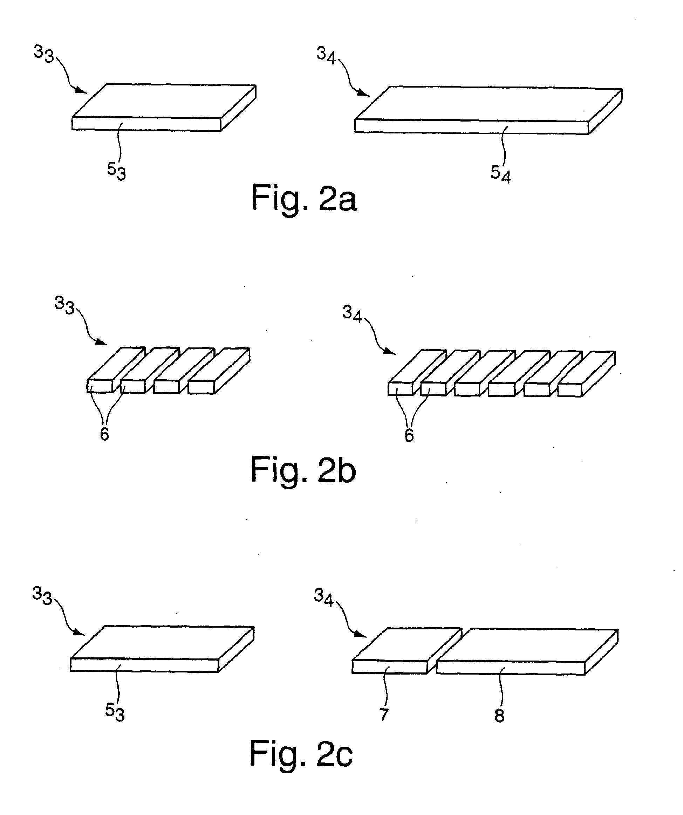

Fig. 2 zeigt verschiedene Ausführungsbeispiele für die in Fig. 1 gezeigten verschieden breiten Streifenemitter $3_3$, $3_4$. In **Fig. 2a** sind die verschieden breiten Streifenemitter $3_2$, $3_3$ jeweils durch einen einzigen Einzelemitter **$5_3$, $5_4$** gebildet. Alternativ zur Verwendung verschieden breiter Einzelemitter können diese auch durch Gruppen mit einer unterschiedlichen Anzahl von Emittern nachgebildet werden In **Fig. 2b** sind die verschieden breiten Streifenemitter $3_3$, $3_4$ jeweils durch eine unterschiedliche Anzahl von identischen und damit gleichbreiten Einzelemittern 6 gebildet, wodurch für alle Streifenemitter gleiche Schwellströme gewährleistet sind. In **Fig. 2c** ist der breitere Streifenemitter $3_4$ durch zwei unterschiedlich breite Einzelemitter **7, 8** gebildet, was sich bei darzustellenden Streifenemittern mit einer Breite größer 200 $\mu$m anbietet.

Vom Diodenlaserbarren der Fig. 1 unterscheidet sich der in **Fig. 3** gezeigte Diodenlaserbarren 1 dadurch, dass hier einige der nebeneinander angeordneten Streifenemitter $3_1$ bis $3_8$ eine jeweils auf die SA-Achse bezogene unterschiedliche Divergenz $\theta_{SA}(1)$ bis $\theta_{SA}(8)$ aufweisen und alle Streifenemitter $3_1$ bis $3_8$ die gleiche Breite w aufweisen. Die Divergenz der Streifenemitter $3_1$ bis $3_8$ nimmt ausgehend von der Mitte der Diodenlaserstruktur 2 zu beiden Rändern der Diodenlaserstruktur 2 hin, insbesondere spiegelsymmetrisch, ab. Es gilt: $\theta_{SA}(4) = \theta_{SA}(5) > \theta_{SA}(3) = \theta_{SA}(6) > \theta_{SA}(2) = \theta_{SA}(7) > \theta_{SA}(1) = \theta_{SA}(8)$. Entsprechend ist das auf die SA-Richtung bezogene Strahlparameterprodukt $BPP_{SA}(i) = w(i) * \theta_{SA}(i)$ = $w * \theta_{SA}(i)$ (i=1, ..., 8) in der Mitte der Diodenlaserstruktur 2 am größten und nimmt zu den beiden Rändern der Diodenlaserstruktur 2 hin, insbesondere spiegelsymmetrisch, ab, d.h., es gilt: $BPP_{SA}(4) = BPP_{SA}(5) > BPP_{SA}(3) = BPP_{SA}(6) > BPP_{SA}(2) = BPP_{SA}(7) > BPP_{SA}(1) = BPP_{SA}(8)$. Wie unten mit Bezug auf Fig. 5 noch näher beschrieben wird, sind die auf die SA-Achse bezogenen Strahlparameterprodukte $BPP_{SA}(1)$ bis $BPP_{SA}(8)$ der Streifenemitter $3_1$ bis $3_8$ derart gewählt, dass sie zu einem in der $BPP_{SA}$-$BPP_{FA}$-Ebene annähernd runden Strahlparameterprodukt optisch zusammensetzbar sind.

**Fig. 4** zeigt schematisch den Strahlengang der von der erfindungsgemäßen Diodenlaserstruktur 2 emittierten und mittels einer Optik **10** in eine runde Faser **11** eingekoppelten Laserstrahlen $4_1$ bis $4_8$. Die Optik 10 transformiert die einzelnen Laserstrahlen $4_1$ bis $4_8$ zu einem gemeinsamen Laserstrahl, in dem die von den Streifenemittern $3_1$ bis $3_8$ ausgehenden Laserstrahlen $4_1$ bis $4_8$ als in Richtung ihrer FA-Achsen übereinander gestapelte parallele Laserstrahlstreifen auf die runde Faser 11 abgebildet werden.

**Fig. 5** zeigt in der $BPP_{SA}$-$BPP_{FA}$-Ebene die Strahlparameterprodukte BPP(1) bis BPP(8) der von den Streifenemittern $3_1$ bis $3_8$ ausgehenden und übereinander gestapelten Laserstrahlstreifen, wobei die Strahlparameterprodukte BPP(1) bis BPP(8) an das runde Strahlparameterprodukt BPP(F) der runden Faser 11 angepasst ist. Dazu sind die Strahlparameterprodukte BPP(1) bis BPP(8) in der SA-Achse an das zugehörige Strahlparameterprodukt des zugehörigen Faserbereichs angepasst. Mit anderen Worten sind die auf die SA-Achse bezogenen Strahlparameterprodukte $BPP_{SA}(1)$ bis $BPP_{SA}(8)$ der Streifenemitter $3_1$ bis $3_8$ derart gewählt, dass sie zu dem in der $BPP_{SA}$-$BPP_{FA}$-Ebene runden Strahlparameterprodukt BPP(F) der Faser 11 optisch zusammensetzt werden können.

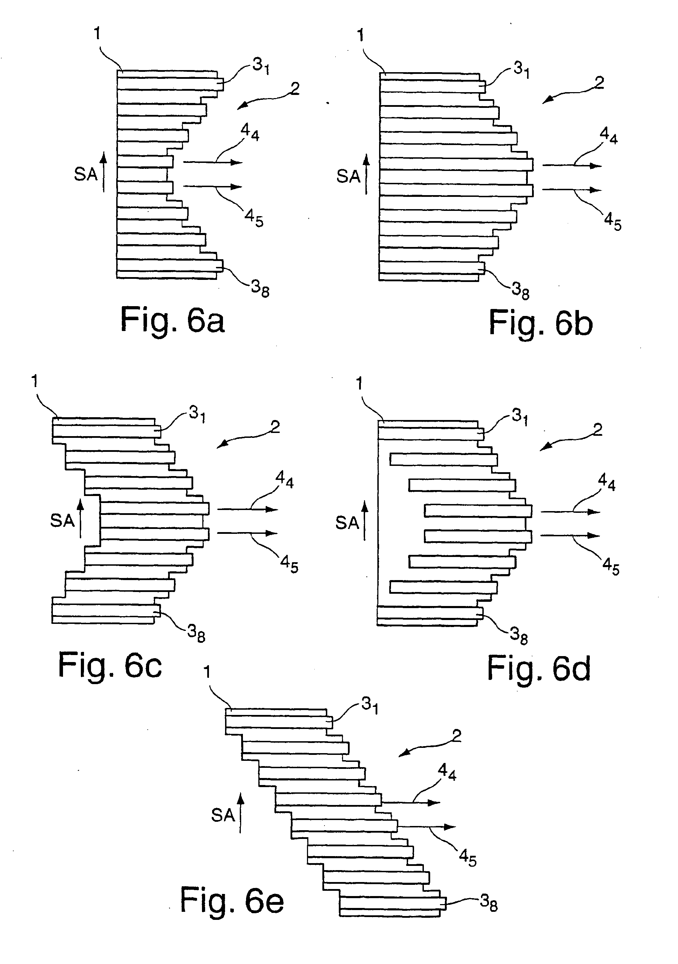

Bei den in Fign. 1 und 3 gezeigten Diodenlaserstrukturen 2 liegen die Auskoppelflächen der Streifenemitter $3_1$ bis $3_8$ in einer gemeinsamen Ebene rechtwinklig zur Ausbreitungsrichtung der von den Streifenemittern $3_1$ bis $3_8$ ausgehenden Laserstrahlen $4_1$ bis $4_8$. **Fign. 6a bis 6e** zeigen weitere Diodenlaserstrukturen 2 von erfindungsgemäßen Diodenlaserbarren 1, bei denen die Auskoppelflächen der Streifenemitter $3_1$ bis $3_8$ nicht in einer gemeinsamen Ebene rechtwinklig zur Ausbreitungsrichtung der von den Streifenemittern $3_1$ bis $3_8$ ausgehenden Laserstrahlen $4_1$ bis $4_8$ liegen.

In Fign. 6a und 6b sind die Auskoppelflächen der Streifenemitter $3_1$ bis $3_8$ mit ihren den Auskoppelflächen abgewandten Enden in einer gemeinsamen Ebene angeordnet, aber in Richtung rechtwinklig zu ihren SA- und FA-Richtungen unterschiedlich lang. Die Länge der Streifenemitter $3_1$ bis $3_8$ nimmt ausgehend von der Mitte der Diodenlaserstruktur 2 zu beiden Rändern der Diodenlaserstruktur 2 hin zu (Fig. 6a) oder ab (Fig. 6b), wodurch die Auskoppelflächen der Streifenemitter $3_1$ bis $3_8$ ausgehend von der Mitte der Diodenlaserstruktur 2 beidseitig in SA-Richtung treppenförmig zueinander versetzt sind.

In Fign. 6c und 6d sind die Streifenemitter $3_1$ bis $3_8$ in Richtung rechtwinklig zu ihren SA- und FA-Richtungen gleich lang und jeweils beidseitig in SA-Richtung treppenförmig zueinander versetzt angeordnet, wodurch ihre Auskoppelflächen ausgehend von der Mitte der Diodenlaserstruktur 2 beidseitig in SA-Richtung treppenförmig zueinander versetzt sind. Während in Fig. 6c der Diodenlaserbarren 1 auf der den Auskoppelflächen der Streifenemitter $3_1$ bis $3_8$ abgewandten Seite entsprechend den Streifenemittern $3_1$ bis $3_8$ ebenfalls treppenförmig ausgebildet ist, ist in Fig. 6d der Diodenlaserbarren 1 auf der den Auskoppelflächen der Streifenemitter $3_1$ bis $3_8$ abgewandten Seite nicht treppenförmig ausgebildet.

In Fig. 6e sind gleich lange Streifenemitter $3_1$ bis $3_8$ jeweils zueinander in SA-Richtung treppenförmig versetzt angeordnet.

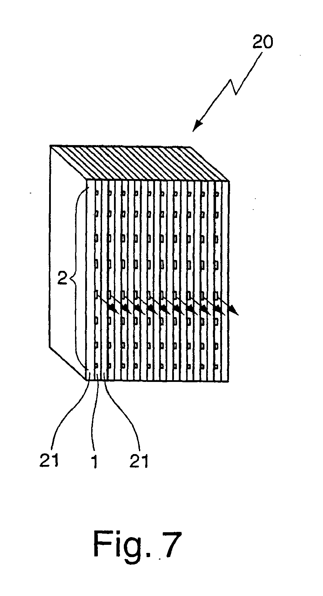

In **Fig. 7** sind mehrere Diodenlaserbarren 1 mit der in Fig. 1 gezeigten Diodenstruktur 2 zu einem Diodenstapel ("Diodenstack") **20** zusammengesetzt, wobei jeder Diodenlaserbarren 1 zwischen zwei Wärmesenken **21** angeordnet ist.

**Patentansprüche**

1. Diodenlaserstruktur (2) mit mehreren nebeneinander angeordneten Streifenemittern ($3_1$ bis $3_8$), die mit ihren SA-Achsen in der gleichen Richtung ausgerichtet und in dieser Richtung versetzt zueinander angeordnet sind, wobei die jeweils auf die SA-Achse bezogenen Strahlparameterprodukte $BPP_{SA}$ zumindest einiger der Streifenemitter ($3_1$ bis $3_8$) verschieden sind,
   **dadurch gekennzeichnet,**
   **dass** das jeweils auf die SA-Achse bezogene Strahlparameterprodukt $BPP_{SA}$ der Streifenemitter ($3_1$ bis $3_8$) ausgehend von der Mitte der Diodenlaserstruktur (2) zu beiden Rändern der Diodenlaserstruktur (2) hin abnimmt, wobei, falls einer oder mehrere der Streifenemitter jeweils durch mehrere Einzelemitter (6;7,8) gebildet Sind, der Abstand in SA-Richtung zwischen benachbarten Einzelemittern eines Streifenemitters Kleiner als der Abstand in SA-Richtung zwischen benachbarten Streifenemittern ist.

2. Diodenlaserstruktur nach Anspruch 1, **dadurch gekennzeichnet, dass** die auf die SA-Achse bezogenen Strahlparameterprodukte $BPP_{SA}$ der Streifenemitter ($3_1$ bis $3_8$) derart gewählt sind, dass sie zu einem in der $BPP_{SA}$-$BPP_{FA}$-Ebene annähernd dem Strahlparameterprodukt einer Faser entsprechenden Strahl entsprechend dem Faserquerschnitt optisch zusammensetzbar sind.

3. Diodenlaserstruktur nach Anspruch 1 oder 2, **da-**

**durch gekennzeichnet, dass** die Auskoppelflächen der Streifenemitter ($3_1$ bis $3_8$) in einer Ebene rechtwinklig zur Ausbreitungsrichtung der von den Streifenemittern ($3_1$ bis $3_8$) ausgehenden Laserstrahlen ($4_1$ bis $4_8$) liegen oder zumindest einige der Auskoppelflächen der Streifenemitter ($3_1$ bis $3_8$) treppenförmig zueinander versetzt angeordnet sind.

4. Diodenlaserstruktur nach einem der vorhergehenden Ansprüche, **dadurch gekennzeichnet, dass** die Streifenemitter ($3_1$ bis $3_8$) durch monochromatische Emitter mit jeweils der gleichen Laserwellenlänge gebildet sind.

5. Diodenlaserstruktur nach einem der vorhergeheriden Ansprüche, **dadurch gekennzeichnet, dass** zumindest einige der Streifenemitter ($3_1$ bis $3_8$) in der Richtung ihrer SA-Achsen verschieden breit sind.

6. Diodenlaserstruktur nach Anspruch 5, **dadurch gekennzeichnet, dass** die Breite ($w_1$ bis $w_8$) der Streifenemitter ($3_1$ bis $3_8$) ausgehend von der Mitte der Diodenlaserstruktur (2) zu beiden Rändern der Diodenlaserstruktur (2) hin abnimmt.

7. Diodenlaserstruktur nach einem der vorhergehenden Ansprüche, **dadurch gekennzeichnet, dass** zumindest einige der Streifenemitter ($3_1$ bis $3_8$) eine jeweils auf die SA-Achse bezogene unterschiedliche Divergenz ($\theta_{SA}$) aufweisen.

8. Diodenlaserstruktur nach Anspruch 7, **dadurch gekennzeichnet, dass** die auf die SA-Achse bezogene Divergenz ($\theta_{SA}$) der Streifenemitter ($3_1$ bis $3_8$) ausgehend von der Mitte der Diodenlaserstruktur (2) zu beiden Rändern der Diodenlaserstruktur (2) hin abnimmt.

9. Diodenlaserstruktur nach einem der vorhergehenden Ansprüche, **dadurch gekennzeichnet, dass** einer oder mehrere der Streifenemitter ($3_1$ bis $3_8$) jeweils durch einen einzigen Einzelemitter ($5_3$, $5_4$) gebildet sind.

10. Diodenlaserstruktur nach einem der vorhergehenden Ansprüche, **dadurch gekennzeichnet, dass** einer oder mehrere der Streifenemitter ($3_1$ bis $3_8$) jeweils durch mehrere Einzelemitter (6; 7, 8) gebildet sind, wobei der Abstand in SA-Richtung zwischen benachbarten Einzelemittern (6; 7, 8) eines Streifenemitters ($3_1$ bis $3_8$) kleiner als der Abstand in SA-Richtung zwischen benachbarten Streifenemittern ($3_1$ bis $3_8$) ist.

11. Diodenlaserstruktur nach Anspruch 10, **dadurch gekennzeichnet, dass** unterschiedlich breite Streifenemitter ($3_1$ bis $3_8$) jeweils durch eine unterschied-

liche Anzahl von gleichbreiten Einzelemittern (6) gebildet sind.

**12.** Diodenlaserstruktur nach Anspruch 10, **dadurch gekennzeichnet, dass** unterschiedlich breite Streifenemitter ($3_1$ bis $3_8$) jeweils durch mehrere unterschiedlich breite Einzelemitter (7, 8) gebildet sind.

**13.** Diodenlaserstruktur nach einem der vorhergehenden Ansprüche, **dadurch gekennzeichnet, dass** den Streifenemittern ($3_1$ bis $3_8$) eine Optik (10) nachgeordnet ist, die die von den Streifenemittern ($3_1$ bis $3_8$) ausgehenden Laserstrahlen ($4_1$ bis $4_8$) als in Richtung ihrer FA-Achsen optisch nebeneinander angeordnete parallele Laserstrahlstreifen auf eine runde Faser (11) abbildet, wobei das auf die SA-Achse bezogene Strahlparameterprodukt $BPP_{SA}$ jedes Laserstrahlstreifens an das auf die SA-Achse bezogene Strahlparameterprodukt $BPP_{SA}$ des zugehörigen Faserbereichs angepasst ist.

**14.** Diodenlaserstruktur nach einem der vorhergehenden Ansprüche, **dadurch gekennzeichnet, dass** die Streifenemitter ($3_1$ bis $3_8$) auf einem Laserdiodenbarren (1) angeordnet sind.

**15.** Diodenlaserstruktur nach Anspruch 14, **dadurch gekennzeichnet, dass** mehrere Laserdiodenbarren (1) zu einem Diodenstapel (20) gestapelt sind.

**Claims**

**1.** Diode laser structure (2) with several stripe emitters ($3_1$ to $3_8$) which are disposed next to each other, the SA axes of which are oriented in the same direction, and which are disposed offset from each other in this direction, wherein the beam parameter products $BPP_{SA}$, with respect to the SA axis, of at least some of the stripe emitters ($3_1$ to $3_8$) are different, **characterized in that**
the beam parameter product $BPP_{SA}$, with respect to the SA axis, of the stripe emitters ($3_1$ to $3_8$) decreases starting from the center of the diode laser structure (2) towards both edges of the diode laser structure (2), wherein in case one or more of the stripe emitters are each formed by several single emitters (6; 7, 8), the separation in SA direction between neighboring single emitters of a stripe emitter is smaller than the separation in SA direction between neighboring stripe emitters.

**2.** Diode laser structure according to claim 1, **characterized in that** the beam parameter products $BPP_{SA}$, with respect to the SA axis, of the stripe emitters ($3_1$ to $3_8$) are selected in such a fashion that they can be optically combined into a beam which approximately corresponds to the beam parameter product of a fiber in the $BPP_{SA}$-$BPP_{FA}$-plane in correspondence with the fiber cross-section.

**3.** Diode laser structure according to claim 1 or 2, **characterized in that** the decoupling surfaces of the stripe emitters ($3_1$ to $3_8$) lie in a plane perpendicular to the propagation direction of the laser beams ($4_1$ to $4_8$) emitted by the stripe emitters ($3_1$ to $3_8$), or at least some of the decoupling surfaces of the stripe emitters ($3_1$ to $3_8$) are disposed offset from each other in the form of steps.

**4.** Diode laser structure according to any one of the preceding claims, **characterized in that** the stripe emitters ($3_1$ to $3_8$) are formed by monochromatic emitters, each having the same laser wavelength.

**5.** Diode laser structure according to any one of the preceding claims, **characterized in that** at least some of the stripe emitters ($3_1$ to $3_8$) have different widths in the direction of their SA axes.

**6.** Diode laser structure according to claim 5, **characterized in that** the width ($w_1$ to $w_8$) of the stripe emitters ($3_1$ to $3_8$) decreases starting from the center of the diode laser structure (2) towards both edges of the diode laser structure (2).

**7.** Diode laser structure according to any one of the preceding claims, **characterized in that** at least some of the stripe emitters ($3_1$ to $3_8$) have each a different divergence ($\theta_{SA}$) with respect to the SA axis.

**8.** Diode laser structure according to claim 7, **characterized in that** the divergence ($\theta_{SA}$), with respect to the SA axis, of the stripe emitters ($3_1$ to $3_8$) decreases starting from the center of the diode laser structure (2) towards both edges of the diode laser structure (2).

**9.** Diode laser structure according to any one of the preceding claims, **characterized in that** one or more of the stripe emitters ($3_1$ to $3_8$) is/are each formed by one single emitter ($5_3$, $5_4$).

**10.** Diode laser structure according to any one of the preceding claims, **characterized in that** one or more of the stripe emitters, ($3_1$ to $3_8$) is/are each formed by several single emitters (6; 7, 8), wherein the separation in SA direction between neighboring single emitters (6; 7, 8) of a stripe emitter ($3_4$ to $3_8$) is smaller than the separation in SA direction between neighboring stripe emitters ($3_1$ to $3_8$).

**11.** Diode laser structure according to claim 10, **characterized in that** stripe emitters ($3_1$ to $3_8$) having different widths are each formed by a different number of equally wide single emitters (6).

**12.** Diode laser structure according to claim 10, **characterized in that** stripe emitters ($3_1$ to $3_8$) having different widths are each formed by several single emitters (7, 8) having different widths.

**13.** Diode laser structure according to any one of the preceding claims, **characterized in that** an optics (10) is disposed downstream of the stripe emitters ($3_1$ to $3_8$), which images the laser beams ($4_1$ to $4_8$) emitted by the stripe emitters ($3_1$ to $3_8$) in the form of parallel laser beam strips which are optically disposed next to each other in the direction of their FA axes, onto a round fiber (11), wherein the beam parameter product $BPP_{SA}$, with respect to the SA axis, of each laser beam strip is adjusted to the beam parameter product $BPP_{SA}$, with respect to the SA axis, of the associated fiber area.

**14.** Diode laser structure according to any one of the preceding claims, **characterized in that** the stripe emitters ($3_1$ to $3_8$) are disposed on a laser diode bar(1).

**15.** Diode laser structure according to claim 14, **characterized in that** several laser diode bars (1) are stacked to form a diode stack (20).


**Revendications**

**1.** Structure de diodes laser (2) comportant plusieurs émetteurs de raies ($3_1$ à $3_8$) disposés les uns à côté des autres, dont les axes SA sont orientés dans la même direction et qui sont décalés les uns par rapport aux autres dans cette direction, les produits des paramètres de faisceau par rapport à l'axe SA $BPP_{SA}$ d'au moins certains des émetteurs de raies ($3_1$ à $3_8$) étant différents,
**caractérisée en ce**
**que** le produit des paramètres de faisceau par rapport à l'axe SA $BPP_{SA}$ des émetteurs de raies ($3_1$ à $3_8$) diminue du milieu de la structure de diodes laser (2) vers les deux bords de la structure de diodes laser (2), sachant que si un ou plusieurs des émetteurs de raies sont formés par plusieurs émetteurs individuels (6; 7, 8), la distance dans la direction SA entre des émetteurs individuels adjacents d'un émetteur de raies est plus petite que la distance dans la direction SA entre des émetteurs de raies adjacents.

**2.** Structure de diodes laser selon la revendication 1, **caractérisée en ce que** les produits des paramètres de faisceau par rapport à l'axe SA $BPP_{SA}$ des émetteurs de raies ($3_1$ à $3_8$) sont choisis de façon à pouvoir être réunis optiquement en un faisceau correspondant approximativement dans le plan $BPP_{SA}$-$BPP_{FA}$ au produit des paramètres de faisceau d'une fibre en fonction de la section de fibre.

**3.** Structure de diodes laser selon la revendication 1 ou 2, **caractérisée en ce que** les surfaces de sortie des émetteurs de raies ($3_1$ à $3_8$) sont situées dans un plan perpendiculaire à la direction de propagation des faisceaux laser ($4_1$ à $4_8$) émanant des émetteurs de raies ($3_1$ à $3_8$) ou au moins certaines des surfaces de sortie des émetteurs de raies ($3_1$ à $3_8$) sont décalées en gradins les unes par rapport aux autres.

**4.** Structure de diodes laser selon une des revendications précédentes, **caractérisée en ce que** les émetteurs de raies ($3_1$ à $3_8$) sont formés d'émetteurs monochromatiques de même longueur d'onde laser.

**5.** Structure de diodes laser selon une des revendications précédentes, **caractérisée en ce qu'**au moins certains des émetteurs de raies ($3_1$ à $3_8$) sont de largeur différente dans la direction de leurs axes SA.

**6.** Structure de diodes laser selon la revendication 5, **caractérisée en ce que** la largeur ($w_1$ à $w_8$) des émetteurs de raies ($3_1$ à $3_8$) diminue du milieu de la structure de diodes laser (2) vers les deux bords de la structure de diodes laser (2).

**7.** Structure de diodes laser selon une des revendications précédentes, **caractérisée en ce qu'**au moins certains des émetteurs de raies ($3_1$ à $3_8$) présentent une divergence différente par rapport à l'axe SA ($\theta_{SA}$).

**8.** Structure de diodes laser selon la revendication 7, **caractérisée en ce que** la divergence par rapport à l'axe SA ($\theta_{SA}$) des émetteurs de raies ($3_1$ à $3_8$) diminue du milieu de la structure de diodes laser (2) vers les deux bords de la structure de diodes laser (2).

**9.** Structure de diodes laser selon une des revendications précédentes, **caractérisée en ce qu'**un ou plusieurs des émetteurs de raies ($3_1$ à $3_8$) sont formés par un seul émetteur individuel ($5_3$, $5_4$).

**10.** Structure de diodes laser selon une des revendications précédentes, **caractérisée en ce qu'**un ou plusieurs des émetteurs de raies ($3_1$ à $3_8$) sont formés par plusieurs émetteurs individuels (6 ; 7, 8), la distance dans la direction SA entre des émetteurs individuels adjacents (6 ; 7, 8) d'un émetteur de raies ($3_1$ à $3_8$) étant plus petite que la distance dans la direction SA entre des émetteurs de raies ($3_1$ à $3_8$) adjacents.

**11.** Structure de diodes laser selon la revendication 10, **caractérisée en ce que** des émetteurs de raies ($3_1$ à $3_8$) de largeur différente sont formés chaque fois par un nombre différent d'émetteurs individuels (6) de même largeur.

**12.** Structure de diodes laser selon la revendication 10, **caractérisée en ce que** des émetteurs de raies ($3_1$ à $3_8$) de largeur différente sont formés chaque fois par plusieurs émetteurs individuels (7, 8) de largeur différente.

**13.** Structure de diodes laser selon une des revendications précédentes, **caractérisée en ce qu'**une optique (10) est placée en aval des émetteurs de raies ($3_1$ à $3_8$), qui reproduit sur une fibre ronde (11) les faisceaux laser ($4_1$ à $4_8$) émanant des émetteurs de raies ($3_1$ à $3_8$) sous la forme de raies de faisceau laser parallèles disposées optiquement les unes à côté des autres dans la direction de leurs axes FA, le produit des paramètres de faisceau par rapport à l'axe SA $BPP_{SA}$ de chaque raie de faisceau laser étant adapté au produit des paramètres de faisceau par rapport à l'axe SA $BPP_{SA}$ de la zone de fibre associée.

**14.** Structure de diodes laser selon une des revendications précédentes, **caractérisée en ce que** les émetteurs de raies ($3_1$ à $3_8$) sont disposés sur une barre de diodes laser (1).

**15.** Structure de diodes laser selon la revendication 14, **caractérisée en ce que** plusieurs barres de diodes laser (1) sont empilées en une pile de diodes (20).

Fig. 1

Fig. 3

EP 2 240 984 B1

Fig. 2a

Fig. 2b

Fig. 2c

Fig. 4

Fig. 5

## Fig. 6a

## Fig. 6b

## Fig. 6c

## Fig. 6d

## Fig. 6e

Fig. 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- JP 6132610 A
- US 5565693 A
- US 20070195850 A1